# EUROPÄISCHE PATENTANMELDUNG

(11) **EP 0 714 229 A2**
(43) Veröffentlichungstag der Anmeldung: **29.05.1996**
(21) Anmeldenummer: 95203110.2
(22) Anmeldetag: 14.11.1995
(51) Int. Cl.: H05K 7/18

(54) **Gestellschrank**

(30) Priorität: 23.11.1994 DE 4441622
(71) Anmelder: Philips Electronics N.V., 5621 BA Eindhoven (NL)
(72) Erfinder: Schuh, Albrecht, c/o Philips Patentverwaltung GmbH, D-22335 Hamburg (DE); Schmitt, Norbert, c/o Philips Patentverwaltung, D-22335 Hamburg (DE)
(74) Vertreter: Erdmann, Anton, Dipl.-Ing.

(57) **Zusammenfassung**

Die Erfindung bezieht sich auf einen Gestellschrank mit einer Bodenplatte (14), mit in den Ecken angeordneten, aufrecht stehenden Holmprofilstäben (15) und mit Wandelementen (10 bis 13). Zur Vereinfachung der Herstellung und Montage wird gemäß der Erfindung vorgeschlagen, daß die Bodenplatte (14) versteift ausgebildet ist und im Bereich jeder Ecke mindestens eine in den Holmprofilstab (15) ragende Innenlasche (22) und mindestens eine an einer Außenkontur des Holmprofilstabes (15) befesigte Außenlasche (23) aufweist.

## Beschreibung

Die Erfindung bezieht sich auf einen Gestellschrank mit einer Bodenplatte, mit in den Ecken angeordneten, aufrecht stehenden Holmprofilstäben und mit Wandelementen.

Ein derartiger Gestellschrank ist z.B. durch die DE 43 33 027 C1 bekannt geworden. Die bekannte Bauart besitzt einen Gestellrahmen mit vier vertikalen Trägern und einem Sockel, an welchem eine horizontal in der Breite des Gestellrahmens verlaufende Querstrebe befestigt ist. In die Querstrebe sind im Bereich der Seiten des Gestellrahmens Bohrungen eingebracht, in die Stellfüße mit ihren Gewindebolzen eingesetzt sind. Damit kann der Gestellrahmen lotrecht ausgerichtet werden. Der Sockel weist Befestigungsaufnahmen auf, in die von seiner Unterseite her Befestigungsschrauben eingeführt und in längsgerichtete Schraubkanäle der Träger eingeschraubt werden können. Die Träger sind mit Längsschlitzen zur Aufnahme von abgekanteten Rändern der Wandelemente versehen. Ferner weisen die hinteren Träger parallel zu den Wandelementen im Abstand verlaufende Befestigungsstege für verstellbare U-förmige Befestigungselemente auf, an denen die Wandelemente angebracht werden können.

Der Erfindung liegt die Aufgabe zugrunde, den Aufwand für die Herstellung und Montage eines eingangs genannten Gestellschrankes zu vereinfachen.

Diese Aufgabe wird gemäß der Erfindung dadurch gelöst, daß die Bodenplatte versteift ausgebildet ist und im Bereich jeder Ecke mindestens eine in den Holmprofilstab ragende Innenlasche und mindestens eine an einer Außenkontur des Holmprofilstabes befestigte Außenlasche aufweist. Damit ergibt sich eine Möglichkeit zur schnellen und einfachen Montage eines derartigen Rahmengestelles, indem zunächst ein Holmprofilstab derart auf eine Ecke aufgesetzt wird, daß die Laschen an den jeweiligen Konturen des Holmprofilstabes anliegen. Zweckmäßig sollten beim Einführen des Holmprofilstabes die Laschen eng an den jeweiligen Konturen des Holmprofilstabes anliegen. Infolge der Reibung zwischen den Laschen und den anliegenden Teilen des Holmprofilstabes bleibt der Holmprofilstab stehen und kann über seine Außenlasche mit einem Befestigungsmittel, z.B. einer Schraube, schnell und einfach befestigt werden. Danach werden auch die anderen Holmprofilstäbe auf die gleiche Weise eingesetzt und befestigt. Infolge der versteift ausgebildeten Bodenplatte besteht keine Gefahr, daß sich diese beim Aufsetzen der Holmprofile verbiegt.

Eine erste Ausgestaltung der Erfindung ist gekennzeichnet durch eine erste Außenlasche, deren Befestigungsebene parallel zur Ebene der Innenlasche verläuft und die an der Außenseite der Wandung befestigt ist. Damit ergibt sich eine erste Befestigungsmöglichkeit des Profilstabes, indem die beiden auf je einer Seite der Wandung angeordneten Laschen gegeneinander gedrückt werden und somit die entsprechende Wandung zwischen sich aufnehmen und einklemmen.

Eine weitere Ausgestaltung der Erfindung ist gekennzeichnet durch eine zweite Außenlasche, deren Befestigungsebene rechtwinklig zur Ebene der Innenlasche verläuft und die an einem rechtwinklig zur genannten Wandung ausgebildeten Steg befestigt ist. Die Befestigung erfolgt ebenfalls z.B. durch eine Schraube und bewirkt eine erhebliche Stabilisierung des Holmprofilstabes, da dieser nunmehr in zwei rechtwinklig zueinander stehenden Befestigungsebenen durch Befestigungsschrauben festgelegt ist. Als Widerhalt dient die innerhalb des Holmprofilstabes an der Innenseite der Wandung anliegende Innenlasche, für die keine Befestigung durch ein Befestigungsmittel erforderlich ist.

Eine weitere Stabilisierung des Holmprofilstabes kann durch eine dritte Außenlasche erreicht werden, deren Befestigungsebene parallel zur Ebene der Innenlasche verläuft und gegenüber der ersten Außenlasche nach innen versetzt ist und die an einer weiteren Außenkontur des Holmprofilstabes befestigt ist. Auch diese Befestigung erfolgt z.B. durch eine Befestigungsschraube. Mit den drei Außenlaschen ergeben sich somit drei durch Schrauben erzielbare Befestigungspunkte zwichen dem Holmprofilstab einerseits und der Bodenplatte andererseits.

In einer weiteren Ausgestaltung der Erfindung ist vorgesehen, daß der Holmprofilstab im Bereich der ersten und dritten Außenlasche eine Nut zur Aufnahme einer Gleitmutter für die jeweilige Befestigungsschraube aufweist und daß die zweite Außenlasche über eine Befestigungsschraube an dem Steg befestigt ist. Diese Ausbildung bietet eine einfache Möglichkeit zur Aufnahme der Befestigungsschrauben, wobei die Nuten bzw. der Steg gleichzeitig zur Aufnahme von Befestigungsschrauben für weitere Bauteile des Gestellschrankes verwendet werden können.

In weiterer Ausgestaltung der Erfindung ist vorgesehen,
- daß die Bodenplatte im Randbereich durch einen aus U-förmigen Profilschienen gebildeten Rahmen versteift ist,
- daß der Rahmen zwei Paare von einander gegenüberliegenden Profilschienen aufweist und
- daß die stirnseitig offenen Profilschienen des ersten Paares sich bis auf einen Spalt bis zum Bodenrand erstrecken und die die des zweiten Paares zwischen den Profilschienen des ersten Paares angeordnet sind.

Dabei sind die Profilschienen jeweils mit ihren Schenkelenden auf der Bodenplatte befestigt, so daß sich insgesamt eine sehr steife und stabile Bodenplatte ergibt.

In weiterer Ausgestaltung ist vorgesehen, daß die ersten und zweiten Außenlaschen jeweils einstückig an den offenen Stirnseiten der Profilschienen des ersten Paares ausgebildet sind und daß die Innenlaschen vorzugsweise einstückig mit der Bodenplatte ausgebildet und mit den offenen Stirnseiten der Profilschienen einen Freiraum bzw. Spalt bilden zum Einfügen einer Innenwandung des Holmprofillstabes. Dabei ist dieser Freiraum so gestaltet, daß der Holmprofilstab beim Aufsetzen auf die Bodenplatte mit der Innenwandung in den Freiraum eingreift und durch Reibkräfte gegen Umfallengehalten wird.

In weiterer Ausgestaltung der Erfindung ist vorgesehen, daß die Bodenplatte im Bereich der Seitenwände und der Rück- und Vorderwand jeweils mit hochgezogenen Flanschen versehen ist, die im Bereich der Rück- und Vorderwand nach innen abgewinkelt sind. Zusammen mit entsprechend montierten Seitenwandungen können damit auch die Brandschutzbestimmungen erfüllt werden. Diese erfordern einen Schutz der Stellfläche gegen brennbare, im Fehlerfall austretende Werkstoffe.

In der Zeichnung ist in den Fig. 1 bis 6 ein Ausführungsbeispiel des Gegenstandes gemäß der Erfindung schematisch dargestellt.

Fig. 1 zeigt einen Gestellschrank in perspektivischer Ansicht,
Fig. 2 zeigt einen Schnitt II-II gemäß Fig. 1,
Fig. 3 zeigt einen Schnitt III-III gemäß Fig. 1,
Fig. 4 zeigt eine vergrößerte perspektivische Darstellung einer Bodenplatte,
Fig. 5 zeigt einen vergrößerten Ausschnitt Z gemäß Fig. 4, und
Fig. 6 zeigt eine vergrößere Draufsicht aus Richtung A gemäß Fig. 4 mit einem eingesetzten Holmprofilstab.

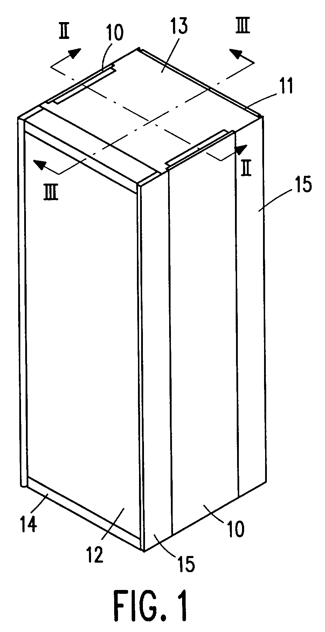

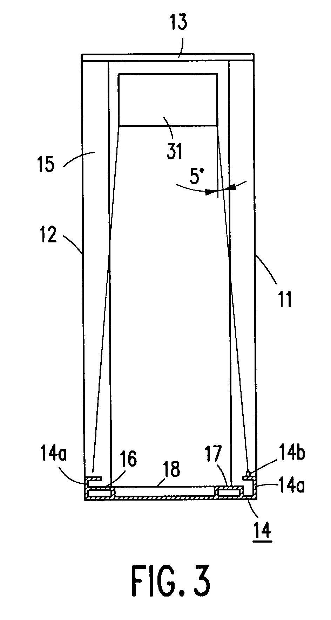

Der Gestellschrank gemäß Fig. 1 bis 4 besitzt zwei Seitenwände 10, eine Rückwand 11, eine Tür 12, ein Deckblech 13 und eine Bodenplatte 14. In den vier Ecken befinden sich vier Holmprofilstäbe 15, die in die Bodenplatte 14 eingesetzt sind und an welcher die übrigen Wandungen des Gestellschrankes befestigt sind.

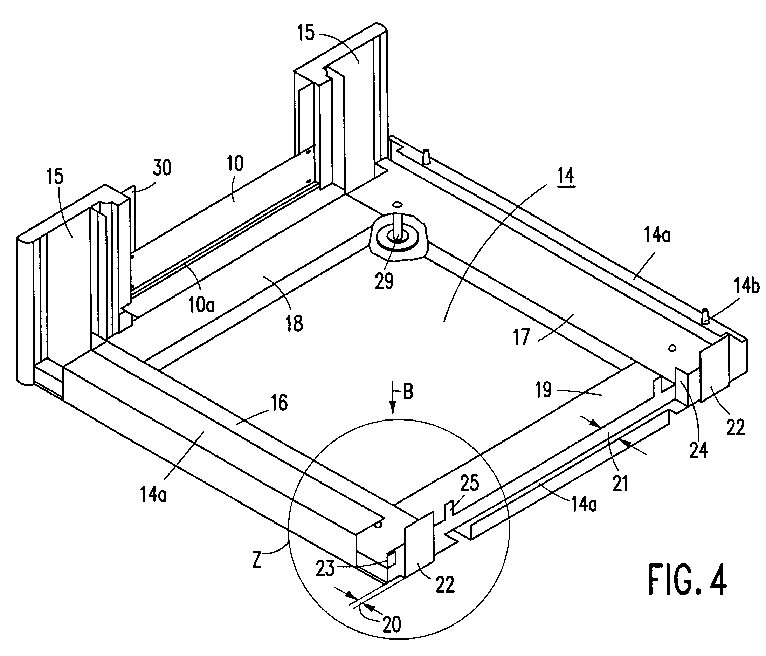

Die in Fig. 4 dargestellte Bodenplatte 14 ist im Randbereich durch vier im Querschnitt U-förmige Profilschienen 16 bis 19 versteift, die miteinander und mit der Bodenplatte verschweißt sind. Die am vorderen und hinteren Rand befindlichen Profilschienen 16, 17 erstrecken sich mit ihren offenen Stirnseiten bis auf einen Abstand 20 bis an den Rand des Bodenbleches 14. Die Profilschienen 18, 19 sind mit einem Abstand 21 zum Rand des Bodenbleches 14 angeordnet und zwischen den beiden Profilschienen 16, 17 befestigt.

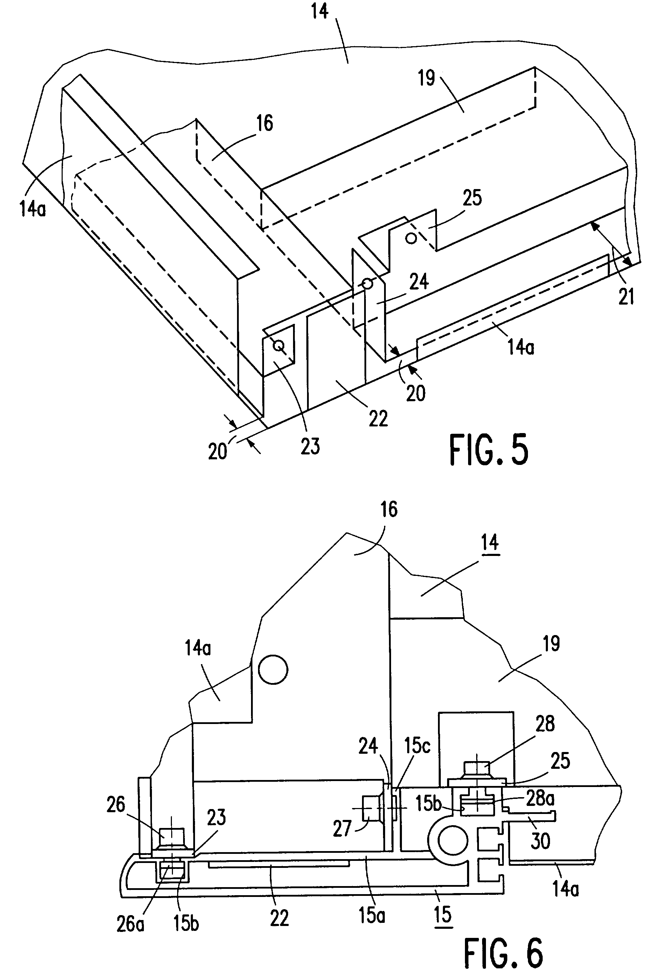

Gemäß Fig. 4 bis 6 besitzt die Bodenplatte 14 gegenüber den offenen Stirnseiten der Profilschienen 16, 17 angeformte, nach oben ragende Innenlaschen 22, die im Abstand 20 zu den Stirnkanten der Profilschienen 16, 17 angeordnet sind. An jeder offenen Stirnseite der beiden Profilschienen 16, 17 ist, wie insbesondere aus Fig. 5 erkennbar ist, eine erste Außenlasche 23 und eine zweite Außenlasche 24 befestigt, während die beiden Profilschienen 18, 19 in jeder Ecke eine weitere Außenlasche 25 aufweisen. Die Innenlasche 22 und die Außenlaschen 23, 25 liegen in zueinander parallelen Ebenen, während die Außenlaschen 24 in dazu rechtwinkligen Ebenen verlaufen.

Beim Aufsetzen eines Profilstabes 15 (Fig. 6) greift die Innenlasche 22 in den Hohlraum des Holmprofilstabes 15 und legt sich an eine Wand 15a an, während die Außenlaschen 23, 24 und 25 über Befestigungsschrauben 26, 27, 28 mit Außenkonturen des Profilstabes befestigt werden. Die Befestigung der Außenlaschen 23, 25 erfolgt über Gleitmuttern 26a, 28a, die in Nuten 15b des Holmprofilstabes 15 gleitend gelagert sind. Die Befestigung der Außenlasche 24 erfolgt über eine Befestigungsschraube 27 an einem rechtwinklig angeformten Steg 15c.

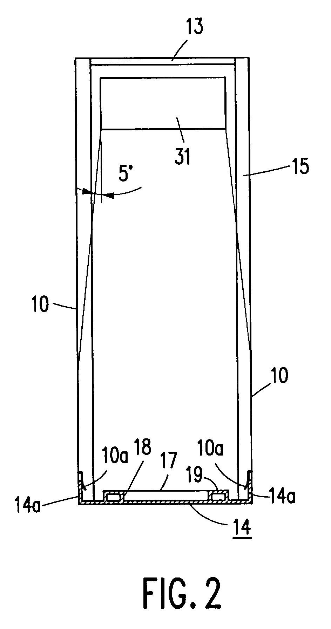

Die Bodenplatte 14 besitzt im Bereich der Seitenwände angeformte hochstehende Flansche 14a, die am vorderen und hinteren Rand nach innen abgewinkelt sind. Mit 29 ist ein integrierter Stellfuß zur Höhenverstellung des Gestellschrankes bezeichnet. Wie aus Fig. 2, 4 erkennbar ist, übergreifen die Seitenwände 10 mit abgewinkelten Teilen 10a die Flansche 14a und werden an Stegen 30 der Holmprofilstäbe 15 befestigt. Die Rückwand 11 wird auf das abgewinkelte Teil 14a aufgesetzt und greift dabei über Bohrungen in aufgesetzte Nippel 14b ein. Gemäß Fig. 2 bis 4 ergibt sich eine etwa wannenförmige Bodenplatte 14, die zusammen mit den Wandungen 10 bis 12 zur Erfüllung der Vorschriften Bandschutzes dient. Die Wandungen und die Bodenplatte greifen so zusammen, daß der Schutz der Stellfläche gegen brennbare, im Fehlerfall austretende Werkstoffe gewährleistet ist. Dazu ist z.B. eine im oberen Teil angeordnete Baugruppe 31 derart angeordnet, daß der vorschriftsmäßige Winkel von 5° eingehalten wird.

## Patentansprüche

1. Gestellschrank mit einer Bodenplatte (14), mit in den Ecken angeordneten, aufrecht stehenden Holmprofilstäben (15) und mit Wandelementen (10 bis 13), dadurch gekennzeichnet, daß die Bodenplatte (14) versteift ausgebildet ist und im Bereich jeder Ecke mindestens eine in den Holmprofilstab (15) ragende Innenlasche (22) und mindestens eine an einer Außenkontur des Holmprofilstabes (15) befestigte Außenlasche (23) aufweist.

2. Gestellschrank nach Anspruch 1, gekennzeichnet durch eine erste Außenlasche (23), deren Befestigungseben parallel zur Ebene der Innenlasche (22) verläuft und die an der Außenseite (15b) des Holmprofilstabes (15) befestigt ist.

3. Gestellschrank nach Anspruch 1, gekennzeichnet durch eine zweiten Außenlasche (24), deren Befestigungsebene rechtwinklig zur Ebene der Innenlasche (22) verläuft und die an einem rechtwinklig vom Holmprofilstab (15) abstehenden Steg (15c) befestigt ist.

4. Gestellschrank nach Anspruch 1, gekennzeichnet durch eine dritte Außenlasche (25), deren Befestigungsebene parallel zur Ebene der Innenlasche (22) verläuft und gegenüber der ersten Außenlasche (23) nach innen versetzt ist und die an einer weiteren Außenkontur (15b) des Profilstabes (15) befestigt ist.

5. Gestellschrank nach einem der Ansprüche 1 bis 4, dadurch gekennzeichnet, daß der Holmprofilstab (15) jeweils im Bereich der ersten und dritten Außenlasche (23, 25) eine Nut (15b) zur Aufnahme einer Gleitmutter (26a) für eine Befestigungsschraube (26, 28) aufweist und daß die zweite Außenlasche (24) über eine Befestigungsschraube (27) an dem Steg (15c) befestigt ist.

6. Gestellschrank nach einem der Ansprüche 1 bis 5, dadurch gekennzeichnet,
- daß die Bodenplatte (14) im Randbereich durch einen aus U-förmigen Profilschienen (16 bis 19) gebildeten Rahmen versteift ist,
- daß der Rahmen zwei Paare (16, 17 und 18, 19) von einander gegenüberliegenden Profilschienen aufweist und
- daß die stirnseitig offenen Profilschienen des ersten Paares (16, 17) sich bis auf einen Spalt (20) bis zum Bodenrand erstrecken und die des zweiten Paares (18, 19) zwischen denen des ersten Paares (16, 17) angeordnet sind.

7. Gestellschrank nach einem der Ansprüche 1 bis 6, dadurch gekennzeichnet, daß die ersten und zweiten Außenlaschen (23, 24) jeweils einstückig an den offenen Stirnseiten der Profilschienen (16, 17,) des ersten Paares ausgebildet sind und daß die Innenlaschen (22) vorzugsweise einstückig mit der Bodenplatte (14) ausgebildet sind und mit den offenen Stirnseiten der Profilschienen (16, 17) einen Spalt (20) zum Einfügen einer Innenwandung (15a) des Holmprofilstabes (15) bilden.

8. Gestellschrank nach einem der Ansprüche 1 bis 7, dadurch gekennzeichnet, daß die dritten Außenlaschen (25) an den Profilschienen (18, 19) des zweiten Paares ausgebildet und im Bereich jeder Ecke angeordnet sind.

9. Gestellschrank nach einem der Ansprüche 1 bis 8, dadurch gekennzeichnet, daß die Bodenplatte (14) im Randbereich mit hochgezogenen Flanschen (14a) versehen ist, die im Bereich der Vorder- und der Rückwand nach innen abgewinkelt sind.
